# EUROPÄISCHE PATENTSCHRIFT

(11) **EP 0 478 612 B1**
(45) Veröffentlichungstag und Bekanntmachung des Hinweises auf die Patenterteilung: **25.08.1993**
(21) Anmeldenummer: 90909140.7
(22) Anmeldetag: 12.06.1990
(51) Int. Cl.: H02M 3/335

(54) **SCHALTNETZTEIL**
CIRCUIT NETWORK
ELEMENT DE RESEAU

(30) Priorität: 21.06.1989 DE 3920235
(43) Veröffentlichungstag der Anmeldung: 08.04.1992
(73) Patentinhaber: DEUTSCHE THOMSON-BRANDT GMBH, 78048 Villingen-Schwenningen (DE)
(72) Erfinder: RILLY, Gérard, D-7731 Unterkirnach (DE); KHA, Kim-Ly, D-7730 Villingen (DE); RODRIGUEZ, José, D-7730 Villingen (DE)
(74) Vertreter: Einsel, Robert, Dipl.-Ing.
(86) Internationale Anmeldenummer: EP9000916
(87) Internationale Veröffentlichungsnummer: WO9016110

(56) Entgegenhaltungen:
- EP-A- 13 332
- EP-A- 279 335
- EP-A- 336 725
- FR-A- 2 608 857

## Beschreibung

Die Erfindung geht aus von einem Schaltnetzteil gemäß dem Oberbegriff des Anspruchs 1.

Bei einem derartigen Schaltnetzteil ist es bekannt (DE-OS 37 05 392), an die Primärwicklung und/oder an die Sekundärwicklung des Transformators ein Netzwerk aus einem Kondensator, einem Widerstand und einer Diode anzuschließen. Dieses Netzwerk, das auch als "snubber" bezeichnet wird, dient zur Begrenzung der Flankensteilheit und der Spannungsspitzen an den Wicklungen des Transformators.

Es hat sich gezeigt, daß an dem Widerstand dieses Netzwerkes eine beachtliche Verlustleistung entsteht, die in der Größenordnung von 5 - 10 % der gesamten vom Netzteil übertragenen Leistung liegt und eine Verringerung des Wirkungsgrades sowie eine unerwünschte Erwärmung der in der Nähe befindlichen Bauteile bewirkt. Diese Verlustleistung wird besonders groß bei Übergang zu höheren Arbeitsfrequenzen des Schaltnetzteils von z.B. 32 kHz und 64 kHz.

Es ist auch ein Schaltnetzteil bekannt (EP-A2 0 336 725; FR 2 608 857), bei dem zur Regelung der Ausgangsspannung parallel zur der Diode, die aus der Impulsspannung an der Sekundärwicklung die Betriebsgleichspannung erzeugt, ein Schalter liegt, der so gesteuert ist, daß nach dem Abklingen des Ladestroms über die Diode in den Ladekondensator ein Strom entgegengesetzt zum Ladestrom von dem Ladekondensator in die Sekundärwicklung hineinfließt.

Es ist auch bekannt (EP-A2 0 279 335), bei einem Schaltnetzteil an die Primärwicklung oder die Sekundärwicklung des Transformators ein Netzwerk aus der Reihenschaltung eines Kondensator und der Parallelschaltung eines Widerstandes und einer Diode anzuschließen. Dieses Netzwerk dient dazu, Spannungsspitzen am Schalttransistor beim Abschalten des Stromes zu verringern. Der Widerstand dieses Netzwerks bewirkt zwangsläufig eine nennenswerte Verlustleistung.

Der Erfindung liegt die Aufgabe zugrunde, bei einem Schaltnetzteil der eingangs beschriebenen Art die an dem Widerstand des letztgenannten Netzwerkes auftretende Verlustleistung zu verringern.

Diese Aufgabe wird durch die im Anspruch 1 angegebene Erfindung gelöst. Vorteilhafte Weiterbildungen der Erfindung sind in den Unteransprüchen angegeben.

Die Erfindung wird anhand der Zeichnung an einem Ausführungsbeispiel erläutert. Darin zeigen
- Fig. 1: ein vereinfachtes Schaltbild eines bekannten Schaltnetzteils,
- Fig. 2: Kurven zur Erläuterung der Wirkungsweise der Fig. 1 und
- Fig. 3: ein erfindungsgemäßes Schaltnetzteil.

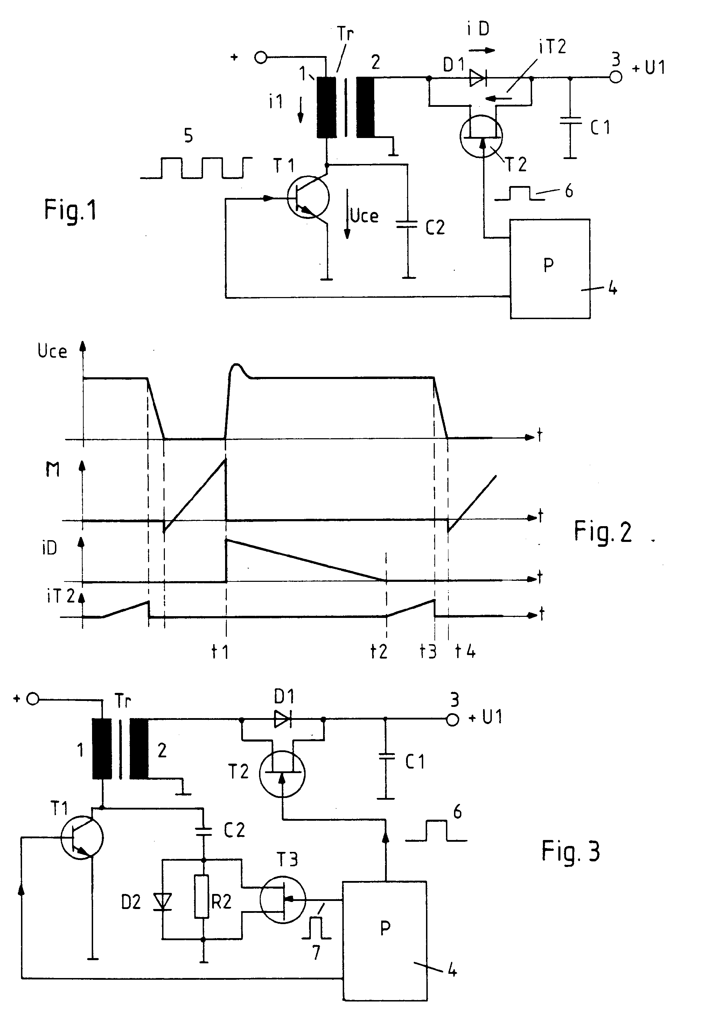

Fig. 1 zeigt ein Schaltnetzteil mit der Primärwicklung 1 des Transformators Tr und dem Schalttransistor T1, die an eine Betriebsspannung angeschlossen sind. Die Sekundärwicklung 2 ist über die Diode D1 an den Ladekondensator C1 angeschlossen, der an der Klemme 3 eine stabilisierte Betriebsspannung +U1 liefert. Der Schalttransistor T1 wird von dem Prozessor 4 mit einer Schaltspannung 5 gesteuert, deren Frequenz in der Größenordnung von 30 - 60 kHz liegt. Die Schaltspannung 5 ist derart impulsbreitenmoduliert, daß durch eine gesteuerte Einschaltdauer des Schalttransistors T1 die Betriebsspannung U1 stabilisiert wird.

Parallel zur Diode D1 liegt der Feldeffekttransistor T2, der von dem Prozessor 4 mit einer Schaltspannung 6 gesteuert wird. Parallel zum Transistor T1 liegt zur Begrenzung der Flankensteilheit und der Spannungsspitzen am Transformator Tr nur der Kondensator C2.

Anhand von Fig. 2 wird die Wirkungsweise erläutert. Im Zeitpunkt t1 wird der Transistor T1 durch die Schaltspannung 5 gesperrt, so daß der Strom i1 auf null befällt. Dadurch wird in der Sekundärwicklung 2 eine Spannung induziert, die einen Ladestrom iD über die Diode D1 in den Ladekondensator C1 bewirkt. Dieser Ladestrom fällt etwa linear ab und erreicht im Zeitpunkt t2 den Wert null. Im Zeitpunkt t2 wird der Transistor T2 leitend und erzeugt einen Strom iT2, der entgegengesetzt zu iD vom dem Ladekondensator C1 in die Sekundärwicklung 2 hineinfließt. Dadurch wird ein Teil der im Zeitpunkt t2 im Ladekondensator C1 gespeicherten Energie in den Transformator Tr zurückgeführt. T2 wird im Zeitpunkt t3 gesperrt. Durch diese Maßnahme wird die Spannung Uce am Transistor T1 so modifiziert, daß diese Spannung gemäß Fig. 2 auf null abgefallen ist, wenn der Transistor T1 im Zeitpunkt t4 neu gezündet wird.

In Fig. 3 ist das genannte Netzwerk mit dem Kondensator C2, der Diode D2 und dem Widerstand R2 parallel zum Transistor T1 vorgesehen. Die am Widerstand R2 auftretende Verlustleistung wird verringert durch den parallel zu R2 geschalteten Feldeffekttransistor T3. Dieser wird durch den Impuls 7 vom Prozessor 4 jeweils während der Impulsflanken am Transformator Tr von t3 - t4 leitend gesteuert und schließt damit den Widerstand R2 kurz. Während der übrigen Zeit, in denen T1 gesperrt ist, ist T3 gesperrt, so daß in dieser Zeit der Widerstand R2 seine Aufgabe zur Dämpfung erfüllen kann. Der Widerstand R2 ist also an sich zur Dämpfung wirksam, die an dem Widerstand R2 abfallende Verlustleitung wird jedoch stark reduziert. Die Schaltung gemäß Fig. 3 ist besonders verteilhaft, wenn in der Schaltung zusätzlich Schwingungen gedämpft werden sollen, die durch C2 und Streuinduktivitäten von Tr entstehen.

Wenn die Schaltung nach Fig. 1 oder 2 mehrere Sekundärwicklungen 2 mit jeweils einer Diode D1 und einem Ladekondensator C1 zur Erzeugung verschiedener Betriebsspannungen aufweist, reicht es, wenn nur bei einer Sekundärwicklung die Maßnahme gemäß Fig. 1 mit dem Transistor T2 getroffen wird.

## Patentansprüche

1. Schaltnetzteil mit einem Transformator (Tr) mit einer in Reihe zu einem Schalttransistor (T1) liegenden Primärwicklung (1) und einer Sekundärwicklung (2), die über eine Diode (D1) an einen Ladekondensator (C1) angeschlossen ist und während der Sperrzeit des Schalttransistors (T1) einen Ladestrom (iD) über die Diode (D1) in den Ladekondensator (D1) liefert, wobei parallel zu der Diode (D1) ein erster Schalter (T2) liegt, der so gesteuert ist, daß nach dem Abklingen des Ladestroms (iD) ein Strom (iT2) entgegengesetzt zum Ladestrom (iD) von dem Ladekondensator (C1) in die Sekundärwicklung (2) fließt, **dadurch gekennzeichnet**, daß parallel zum Schalttransistor (T1) ein Netzwerk aus der Reihenschaltung eines Kondensators (C2) und der Parallelschaltung eines Widerstandes (R2) und einer Diode (D2) angeschlossen ist und parallel zu dem Widerstand (R2) ein zweiter Schalter (T3) liegt, der durch eine Steuerspannung (7) während der Impulsflanken der Spannung (Uce) an der Primärwicklung (1) leitend gesteuert ist.

2. Schaltung nach Anspruch 1, **dadurch gekennzeichnet**, daß der erste oder zweite Schalter (T2, T3) durch einen Feldeffekttransistor (T2, T3) gebildet ist.

3. Schaltung nach Anspruch 1 oder 2, **dadurch gekennzeichnet**, daß der Schalter (T2, T3) durch einen Impuls (6, 7) von einem Prozessor (4) gesteuert ist, der auch den Schalttransistor (T1) im Sinne einer Stabilisierung der erzeugten Betriebsspannung (U1) steuert.

4. Schaltung nach Anspruch 1, **dadurch gekennzeichnet**, daß bei mehreren Sekundärwicklungen mit je einer Diode und einem Ladekondensator der erste Schalter (T2) nur bei einer Sekundärwicklung vorgesehen ist.

## Claims

1. A switched-mode power supply unit with a transformer (Tr) commprising a primary winding (1), which is arranged in series with a switching transistor (T1), and a secondary winding (2) which is connected via a diode (D1) to a charging capacitor (C1) and during the non-conductive period of the switching transistor (T1) supplies a charging current (iD) via the diode (D1) to the charging capacitor (D1), wherein a first switch (T2) is arranged in parallel to the diode (D1), which first switch (T2) is controlled in such manner that when the charging current (iD) has died out a current (iT2) opposed to the charging current (iD) flows from the charging capacitor (C1) into the secondary winding (2), characterised in that a network comprising the series connection of a capacitor (C2) and the parallel connection of a resistor (R2) and a diode (D2) is connected in parallel to the switching transistor (T1), and a second switch (T3) is arranged in parallel to the resistor (R2), which second switch (T3) is driven conductive by a control voltage (7) during the pulse flanks of the voltage (Uce) across the primary winding (1).

2. A circuit as claimed in Claim 1, characterised in that the first or second switch (T2, T3) is formed by a field effect transistor (T2, T3).

3. A circuit as claimed in Claim 1 or 2, characterised in that the switch (T2, T3) is controlled by a pulse (6, 7) from a processor (4) which also controls the switching transistor (T1) in terms of stabilizing the generated operating voltage (U1).

4. A circuit as claimed in Claim 1, characterised in that in the case of a plurality of secondary windings each with a diode and a charging capacitor, the first switch (T2) is provided only in the case of one secondary winding.

## Revendications

1. Bloc d'alimentation et de commutation avec un transformateur (Tr) avec un enroulement primaire (1) qui est monté en série avec un transistor de commutation (T1) et avec un enroulement secondaire (2) qui est raccordé par une diode (D1) à un condensateur de lissage (C1) et qui donne, pendant le temps de blocage du transistor de commutation (T1), un courant de charge (iD) par la diode (D1) dans le condensateur de lissage (C1), un premier commutateur (T2) étant parallèle à la diode (D1) et étant commandé de telle manière qu'après amortissement du courant de charge (iD) un courant (iT2) passe en étant opposé au courant de charge (iD) du condensateur de lissage (C1) dans l'enroulement secondaire (2), **caractérisé en ce** qu'un réseau composé du montage en série d'un condensateur (C2) et du montage en parallèle d'une résistance (R2) et d'une diode (D2) est raccordé parallèlement au transistor de commutation (T1) et qu'il y a un second commutateur (T3) qui est parallèle à la résistance (R2), commutateur qui est commandé pour être conducteur par une tension de commande (7) pendant les flancs d'impulsion de la tension (Uce) sur l'enroulement primaire (1).

2. Circuit selon la revendication 1, **caractérisé en ce** que le premier ou le second commutateur (T2, T3) est formé par un transistor à effet de champ (T2, T3).

3. Circuit selon la revendication 1 ou 2, **caractérisé en ce** que le commutateur (T2, T3) est commandé par une impulsion (6, 7) par un processeur (4) qui commande aussi le transistor de commutation (T1) pour obtenir une stabilisation de la tension de fonctionnement (U1) produite.

4. Circuit selon la revendication 1, **caractérisé en ce que** le premier commutateur (T2) n'est prévu que pour un enroulement secondaire lorsqu'il y a plusieurs enroulements secondaires avec chacun une diode et un condensateur de lissage.
